Europäisches Patentamt

(19) European Patent Office

Office européen des brevets

(11) Numéro de publication: **0 241 321**
**B1**

(12) **FASCICULE DE BREVET EUROPEEN**

(45) Date de publication du fascicule du brevet:
05.12.90

(21) Numéro de dépôt: 87400451.8

(22) Date de dépôt: 02.03.87

(51) Int. Cl.⁵: **C30B 7/00**, C30B 29/14

(54) Procédé de préparation de cristaux de berlinite à haut coefficient de surtension.

(30) Priorité: 04.03.86 FR 8603009

(43) Date de publication de la demande:
14.10.87 Bulletin 87/42

(45) Mention de la délivrance du brevet:
05.12.90 Bulletin 90/49

(84) Etats contractants désignés:
DE GB NL

(56) Documents cités:
FR-A- 2 559 165
US-A- 4 300 979

(73) Titulaire: **CENTRE NATIONAL DE LA RECHERCHE SCIENTIFIQUE (CNRS), 15, Quai Anatole France, F-75007 Paris(FR)**
Titulaire: **ETAT FRANCAIS représenté par le Ministre des PTT (Centre National d'Etudes des Télécommunications), 38-40 rue du Général Leclerc, F-92131 Issy-les-Moulineaux(FR)**

(72) Inventeur: **Philippot, Etienne, Chemin des Aires Saint Jean de Cuculles, F-34270 Saint Mathieu de Treviers(FR)**
Inventeur: **Jumas, Jean-Claude, 21, Lotissement du Parc Jacou, F-34170 Caltenau le Lez(FR)**
Inventeur: **Goiffon, Aline, 393, rue des Olivettes La Colline, F-34980 Saint Clément la Rivière(FR)**
Inventeur: **Maurin, Maurice, La Lézardière 944, rue de la Roqueturière, F-34100 Montpellier(FR)**
Inventeur: **Doukhan, Jean-Claude, 5, Allée des Arbrisseaux, F-59650 Villeneuve d'Ascq(FR)**
Inventeur: **Zarka, Albert, 7, rue Louise Thuliez, F-75019 Paris(FR)**
Inventeur: **Capelle, Bernard, 8, allée Hector Berlioz, F-94800 Villejuif(FR)**
Inventeur: **Toudic, Yves, 4, rue des Blés d'Or, Ploubezre F-22300 Lannion(FR)**
Inventeur: **Detaint, Jacques, 121, rue de Bondy, F-93250 Villemomble(FR)**
Inventeur: **Schwartzel, Jacquie, 34, place d'Ardenay, F-91120 Palaiseau(FR)**

**Description**

La présente invention concerne un procédé de croissance de cristaux de berlinite à haut coefficient de surtension.

La densité du trafic et le niveau des fréquences utilisées sont tels qu'il est devenu indispensable, dans l'établissement d'une liaison, d'utiliser des dispositifs de filtrage (systèmes à onde de volume ou de surface). Le composant de base de ces dispositifs est un résonateur dont la qualité dépend du matériau piézoélectrique nécessaire à sa réalisation.

Pour réaliser un résonateur à ondes de volume ou de surface, il faut pouvoir disposer de cristaux de volume important (plusieurs $cm^3$) possédant les meilleures qualités piézoélectriques et mécaniques possibles.

Trois cristaux sont utilisés : le quartz, la berlinite ($AlPO_4$) et le tantalate de lithium ($LiTaO_3$). La berlinite est intermédiaire entre les deux autres matériaux, tant du point de vue bande passante que coefficient de couplage électromécanique. En outre, sa dérive en fréquence en fonction de la température est réduite selon les cas connus d'un facteur variant autour de 1,5 à 2.

Toutefois, l'utilisation industrielle de la berlinite reste limitée par des facteurs de surtension toujours faibles : quelques milliers en comparaison des $10^6$ du quartz.

La méthode utilisée pour la croissance de la berlinite est la méthode hydrothermale. En milieu phosphorique la solubilité de la berlinite est rétrograde ; en conséquence, deux procédés peuvent être mis en jeu :

1°) La méthode dite de gradient inverse :
On utilise un autoclave comportant 2 zones :
une zone froide où est placé le corps-mère et une zone chaude où sont placés les germes. Le gradient de température peut être vertical (autoclave en position verticale) ; dans ce cas, le transport de matériau du corps-mère vers les germes par l'intermédiaire du solvant se fait par courants de convection. Le gradient de température peut être horizontal (autoclave en position horizontale) ; dans ce cas, le transport de matériau se fait par diffusion, on peut également lui adjoindre un gradient vertical.

2°) La méthode dite de Montée Lente en température (ML) :
La croissance commence à une température dite de début de cristallisation où la solution est présaturée. Elle se poursuit par augmentation régulière de la température : la solution se trouve alors sursaturée et le matériau se dépose sur des germes ou en l'absence de ceux-ci sur les parois de l'autoclave.

Les deux procédés peuvent être utilisés conjointement.

D'après les courbes de solubilité de la berlinite dans les solvants considérés ($H_3PO_4$, HCl) il est possible de faire croître $AlPO_4$ entre 135°C et environ 400°C. Cependant, le domaine habituellement utilisé est compris entre 150°C et 210°C dans le cas de la croissance sur germes.

Néanmoins, actuellement ces procédés ne permettent pas d'obtenir des cristaux de berlinite avec des coefficients de surtension permettant leur utilisation industrielle.

La présente invention concerne un procédé de préparation de cristaux de berlinite ($AlPO_4$) à haut coefficient de surtension, à partir de germes ou de lames cristallines de $AlPO_4$, par une méthode hydrothermale, caractérisé en ce que la solution de cristallisation est une solution sulfurique de $AlPO_4$.

Il doit être bien entendu que la méthode hydrothermale mise en oeuvre peut être l'une quelconque des méthodes décrites précédemment, à savoir gradient horizontal (GHT), gradient vertical (GVT) ou MLT.

Sauf indication contraire, les conditions de mise en oeuvre de ces méthodes seront considérées comme connues de l'homme de l'art ou pourront être déterminées par des procédés connus.

L'utilisation d'une solution sulfurique seule ou d'une solution constituée d'un mélange acide sulfurique/acide phosphorique permet d'obtenir des cristaux de berlinite avec des coefficients de surtension élevés.

En outre, l'utilisation de solution sulfurique permet de préparer la solution de cristallisation contenant le corps-mère directement par réaction du sulfate d'aluminium hydraté sur $H_3PO_4$, éventuellement en présence de $H_2SO_4$, les proportions de réactifs étant calculées pour obtenir une solution de cristallisation ayant les dosages désirés selon la réaction : $Al_2(SO_4)_3, xH_2O + 2H_3PO_4 \longrightarrow 2AlPO_4 + 3H_2SO_4 + xH_2O$

La réaction peut être effectuée, de préférence, directement dans l'autoclave de cristallisation.

En effectuant des cycles de cristallisation rapide sur les solutions d'$AlPO_4$ ainsi obtenues, on obtient des cristaux de berlinite de petite taille qui pourront constituer le corps-mère.

Cette méthode présente de nombreux avantages :
- obtention de berlinite de haute pureté,
- coût réduit dû au faible prix du sulfate d'aluminium comparé à celui de l'alumine ultra-pure et à une plus grande rapidité de réaction par rapport à $Al_2O_3$,
- préparation simultanée de berlinite et de solution de berlinite en milieu sulfurique utilisable pour la cristallogénèse en montée lente.

Bien entendu, il est possible de préparer $AlPO_4$ pour la solution par d'autres procédés, par exemple à partir d'alumine de haute pureté et d'acide phosphorique, $AlPO_4$ étant alors dissous dans l'acide sulfurique ou le mélange acide sulfurique/acide phosphorique pour constituer la solution et le corps-mère.

Les études qui ont été conduites pour déterminer les paramètres de cristallisation ont mis en évidence l'influence de la teneur en eau des cristaux sur leurs propriétés. En particulier, les cristaux présentant une forte teneur en eau présentent également un faible coefficient de surtension. En outre, l'inclusion d'eau dans le cristal peut avoir un effet néfaste sur la fiabilité et la stabilité des dispositifs réalisés à partir des résonateurs.

Il est donc intéressant d'obtenir des cristaux à faible teneur en eau.

L'intérêt d'utiliser $H_2SO_4$ comme solvant par rapport à $H_3PO_4$ par exemple est que sa tension de vapeur est nettement plus faible, ce qui diminue la pression à laquelle se déroule la cristallisation et limite l'inclusion d'eau dans le cristal.

Il est également intéressant, pour diminuer la pression dans l'autoclave de cristallisation, de limiter le remplissage de celui-ci, par exemple en le remplissant à 80-85 % de son volume global.

La pente des courbes de solubilité permet de prévoir l'utilisation possible des solutions de $H_2SO_4$ entre environ 190°C et 300°C, la gamme préférée de température étant de 200°C à 260°C.

Ces températures présentent, en outre, l'avantage de correspondre à une solubilité moins grande de l'eau dans le cristal que les températures plus basses souvent mises en oeuvre dans la technique antérieure avec les solutions de $H_3PO_4$.

Les autres paramètres de la méthode pourront être déterminés en fonction notamment :
- de la technique hydrothermale utilisée,
- de la solution utilisée,
- éventuellement de certains paramètres de l'autoclave.

La présente invention concerne également les cristaux de berlinite obtenus selon le procédé de l'invention à partir d'une solution sulfurique qui seront appelés ci-après "cristaux de berlinite obtenus en solution sulfurique".

Les cristaux de berlinite obtenus en solution de $H_2SO_4$ ont une morphologie différente des cristaux obtenus en $H_3PO_4$, à savoir si l'on part d'un germe Y (coupe parallèle aux face naturelles de croissance m) :

1°) le développement des faces $\pi$ et $\pi'$ est beaucoup plus important dans le cas de $H_2SO_4$,

2°) les vitesses de croissance selon X et Z sont très différentes, ce qui conduit à des cristaux plus isométriques dans le cas de $H_2SO_4$, (la vitesse de croissance suivant X est nettement plus élevée dans le cas de $H_2SO_4$ et se rapproche de la vitesse de croissance suivant Z).

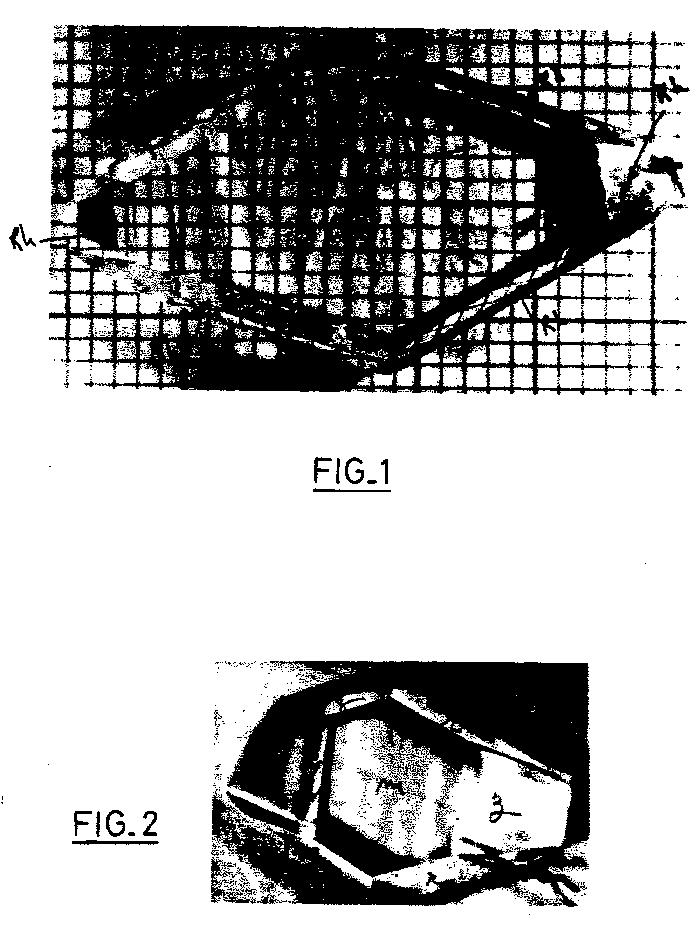

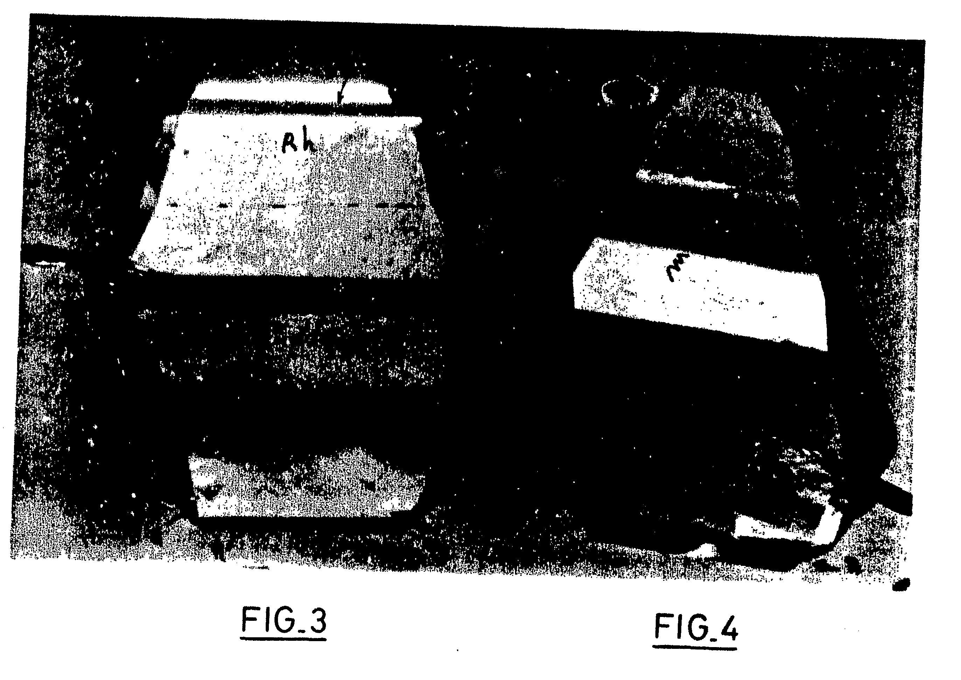

Les figures ci-jointes sont des photographies de cristaux obtenus, d'une part, à partir de solution dans $H_3PO_4$ à 160-180°C (figure 1, en GVT et figure 2, en GHT) et, d'autre part, à partir de solution dans $H_2SO_4$ à 210°C (figures 3 et 4).

Sur ces figures, $\pi = \pi$ ou $\pi'$ et Rh = r ou z, face du rhomboèdre, m indique les faces naturelles de croissance.

Les cristaux ainsi obtenus à partir de solution de $H_2SO_4$ présentent une morphologie très différente de celle des cristaux de la technique antérieure, outre leurs propriétés améliorées.

Les exemples ci-après sont destinés à illustrer d'autres avantages et caractéristiques de la présente invention.

EXEMPLE 1

On prépare une solution de sulfate d'aluminium hydraté dans un mélange $H_3PO_4$-$H_2SO_4$ de façon qu'après réaction la solution soit 4M en $AlPO_4$ et 0M en $H_2SO_4$. Cette solution placée dans un autoclave chemisé téflon rempli à 80 % subit 15 cycles de température 200-270°C à raison de 1 cycle par jour. Après refroidissement rapide de l'autoclave, on obtient des cristaux de berlinite de dimensions comprises entre 2 et 4 mm.

EXEMPLE 2

Le sulfate d'aluminium hydraté est dissous dans $H_3PO_4$ en proportions telles qu'après réaction la solution soit 3,5M en $AlPO_4$ et 5,25M en $H_2SO_4$. La solution obtenue est placée dans un autoclave chemisé téflon rempli à 80 %. La solution subit 3 cycles de température 200-270°C à raison de 1 cycle par jour. Après refroidissement rapide de l'autoclave, la berlinite est obtenue sous forme pulvérulente.

EXEMPLE 3

Dans une enceinte en verre, scellée sous vide, de diamètre extérieur 30 mm et présentant un étranglement, de diamètre intérieur 10 mm, au tiers de sa longueur on dispose :
- dans la partie la plus courte, partie froide, 20 g de phosphate d'aluminium sous forme de poudre microcristalline,
- dans la partie la plus longue, partie chaude, 6 lames (orientations X, Y, Z et r) de berlinite; ces lames sont percées et suspendues à l'aide de fils d'or à une potence en verre.

Le remplissage de l'enceinte est assuré à 80 % par une solution $H_2SO_4/AlPO_4$ respectivement 5M et 2M. L'enceinte est portée le plus rapidement possible aux températures d'équilibre désirées : partie froide $T_1 = 190°C$, partie chaude $T_2 = 200°C$ avec un gradient de température vertical dans la partie chaude de 3°C.

Après un temps d'expérience de 2 semaines, on enregistre une croissance de 0,25; 0,13; 0,40 et 0,004 mm/jour/face respectivement pour les orientations X, Y, Z et r.

### EXEMPLE 4

Une enceinte en verre, scellée sous vide, de diamètre extérieur 30 mm et de 250 mm de long est remplie à 80 % d'une solution $H_2SO_4/AlPO_4$, respectivement 5M et 2,5M, dans laquelle on place 8 lames Y de berlinite. Ces lames sont percées et suspendues à l'aide de fils d'or à une potence en verre. La température de début de cristallisation de la solution préalablement déterminée à partir des courbes de solubilité de la berlinite dans $H_2SO_4$ est de 175°C.

L'enceinte est portée le plus rapidement possible à la température de début de cristallisation 175°C et on programme ensuite une montée lente en température de 1°C/jour jusqu'à 200°C puis de 2°C/jour jusqu'à 220°C.

Après ouverture, au bout de 35 jours, on observe une croissance des lames Y de 0,14 mm/jour/face.

### EXEMPLE 5

Un autoclave chemisé platine (diamètre : 40 mm, hauteur : 300 mm) de 375 cm³ de volume utile est utilisé pour la technique dite de gradient de température vertical avec un rapport partie froide/partie chaude = 2/5.

Dans la partie froide on dispose 50 g de phosphate d'aluminium en microcristaux de dimensions supérieures à 1,5 mm dans le panier à corps-mère. Dans la partie chaude, 8 lames de berlinite de diverses orientations (X, Y, Z et r) sont suspendues à l'aide de fils d'or à une échelle en platine. L'autoclave est rempli à 80 % avec une solution $H_2SO_4/AlPO_4$ respectivement 6M et 2,2M.

L'enceinte est portée le plus rapidement possible aux températures d'équilibre désirées : partie froide $T_1 : 195°C$, partie chaude $T_2 : 200°C$.

Au bout d'un temps de 3 semaines et après ouverture de l'autoclave, on enregistre une croissance de 0,22; 0,13, 0,40 et 0,04 mm/jour/face pour les orientations X, Y, Z et r.

### EXEMPLE 6

On utilise la même enceinte que pour l'exemple 3. Dans la partie froide, on dispose 50 g de phosphate d'aluminium en microcristaux dans le panier à corps-mère. Ces microcristaux ont des dimensions comprises entre 1 et 2 mm. Dans la partie chaude, 8 lames de berlinite, d'orientation Y, sont suspendues à l'échelle de platine par l'intermédiaire de fils d'or.

L'autoclave est rempli à 80 % avec une solution $H_2SO_4,H_3PO_4/AlPO_4$ respectivement 6M, 6M et 2,5M puis porté le plus rapidement possible aux températures d'équilibre désirées. La température de début de cristallisation est préalablement déterminée par un essai "à blanc" dans lequel les lames de berlinite sont remplacées par des germes de qualité médiocre. Elle est, pour la solution utilisée, de 195°C.

Avec un gradient de température de 5°C et au bout d'un temps d'expérience de 3 semaines, on enregistre une croissance moyenne de 0,08 mm/jour/face pour les lames d'orientation Y.

### EXEMPLE 7

Des cristaux réalisés comme dans l'exemple 5 en solution $H_2SO_4$ 6,5M présentent les caractéristiques suivantes :
(Q = coefficient de surtension) :
à $T_1 = 200°C$ Q = 48 000 à 5 MHz en fondamental
à $T_2 = 210°C$ Q = 50 000 à 5 MHz en fondamental
à $T_2 = 220°C$ Q= 64 000 à 5 MHz en fondamental
ce qui peut se comparer au coefficient du quartz de l'ordre de $10^6$.

Ces résultats démontrent également l'intérêt des températures élevées pour obtenir des "cristaux sec".

Le tableau ci-après schématise la comparaison de la berlinite selon l'invention avec le quartz (résonateur en mode d'épaisseur de lames Y tournées à la même fréquence), étant admis l'hypothèse que la berlinite présente des valeurs comparables des constantes C, E, EPS et du CT de premier ordre mais beaucoup plus faibles pour les CT d'ordre supérieur.

| Coefficient de couplage | : | augmenté d'un facteur 1,4-1,5 |
| Largeur de bande des filtres (coupe AT) | : | double |
| Sensibilité angulaire (C.T.F. 1° ordre) | : | diminuée d'un facteur 1,5 |
| Stabilité thermique (C.T.F. ordres supérieurs) | : | meilleure |
| Coefficients de surtension | : | déjà suffisants (comparables) |
| Epaisseur des lames (AT) | : | diminuée d'un facteur 1,13 |
| Dimension des électrodes (AT) | : | diminuée d'un facteur 1,16 |

**Revendications**

1. Procédé de préparation de cristaux de berlinite AlPO$_4$, à haut coefficient de surtension, à partir de germes ou de lames cristallines d'AlPO$_4$, par une méthode hydrothermale, caractérisé en ce que la solution de cristallisation est une solution sulfurique d'AlPO$_4$.

2. Procédé selon la revendication 1, caractérisé en ce que la solution de cristallisation est une solution d'AlPO$_4$ dans un mélange de H$_2$SO$_4$ et de H$_3$PO$_4$.

3. Procédé selon la revendication 1, caractérisé en ce que la solution de cristallisation est une solution d'AlPO$_4$ dans H$_2$SO$_4$.

4. Procédé selon l'une des revendications 1 à 3, caractérisé en ce que la solution de cristallisation et le corps-mère sont préparés par action de H$_3$PO$_4$ sur du sulfate d'aluminium hydraté pour obtenir directement en fin de réaction le corps-mère dans la solution de cristallisation.

5. Procédé selon la revendication 4, caractérisé en ce que la réaction est conduite en présence de H$_2$SO$_4$.

6. Procédé selon l'une des revendications 4 et 5, caractérisé en ce que la réaction est effectuée dans l'enceinte de cristallisation qui servira à la mise en œuvre de la méthode hydrothermale.

7. Procédé selon l'une des revendications 1 à 6, caractérisé en ce que l'enceinte de cristallisation est remplie à 80–85% de son volume par la solution de cristallisation.

8. Procédé selon l'une des revendications 1 à 7, caractérisé en ce que les températures de cristallisation sont comprises entre 190°C et 300°C.

9. Procédé selon la revendication 8, caractérisé en ce que les températures de cristallisation sont comprises entre 200°C et 260°C.

10. Monocristal de berlinite obtenu par le procédé selon l'une quelconque des revendications 1 à 9.

11. Monocristal de berlinite ayant un coefficient de surtension supérieur à 50 000 à 5 MHz en mode fondamental.

**Claims**

1. Process for the preparation of crystals of berlinite AlPO$_4$, with a high O factor, from seeds or crystalline flakes of AlPO$_4$, by a hydrothermal method, characterized in that the crystallization solution is a sulfuric solution of AlPO$_4$.

2. Process according to Claim 1, wherein the crystallization solution is a solution of AlPO$_4$ in a mixture of H$_2$SO$_4$ and H$_2$PO$_4$.

3. Process according to Claim 1, wherein the crystallization solution is a solution of AlPO$_4$ in H$_2$SO$_4$.

4. Process according to one of Claims 1 to 3, wherein the crystallization solution and the mother-body are prepared by the action of H$_3$PO$_4$ on hydrated aluminium sulfate to obtain directly at the end of the reaction the mother-body in the crystallization solution.

5. Process according to Claim 4, wherein the reaction is conducted in the presence of H$_2$SO$_4$.

6. Process according to one of Claims 4 and 5, wherein the reaction is carried out in the crystallization vessel which will serve for the practising of the hydrothermal method.

7. Process according to one of Claims 1 to 6, wherein the crystallization vessel is filled to 80–85% of its volume by the crystallization solution.

8. Process according to one of Claims 1 to 7, wherein the crystallization temperatures are comprised between 190°C and 300°C.

9. Process according to Claim 8, wherein the crystallization temperatures are comprised between 200°C and 260°C.

10. Berlinite monocrystal obtianed from the process according to any of claims 1 to 9.

11. Berlinite monocrystal having a Q factor higher than 50 000 at 5 MHz in the fundamental mode.

**Patentansprüche**

1. Verfahren zur Herstellung von Berlinitkristallen (AlPO$_4$) mit hohem Überspannungskoeffizienten auf der Grundlage von AlPO$_4$-Kristallkeimen oder -plättchen auf hydrothermalem Wege, dadurch gekennzeichnet, daß die Kristallisationslösung aus einer Schwefelsäurelösung von AlPO$_4$ besteht.

2. Verfahren nach Anspruch 1, dadurch gekennzeichnet, daß die Kristallisationslösung aus einer Lösung von AlPO$_4$ in einer Mischung aus H$_2$SO$_4$ und H$_3$PO$_4$ besteht.

3. Verfahren nach Anspruch 1, dadurch gekennzeichnet, daß die Kristallisationslösung aus einer Lösung von AlPO$_4$ in H$_2$SO$_4$ besteht.

4. Verfahren nach einem der Ansprüche 1 bis 3, dadurch gekennzeichnet, daß die Kristallisationslösung und die Mutterkörperchen durch Einwirkung von H$_3$PO$_4$ auf Aluminiumsulfathydrat zur direkten Gewinnung (im Laufe der Reaktion) der Mutterkörperchen in der Kristallisationslösung hergestellt werden.

5. Verfahren nach Anspruch 4, dadurch gekennzeichnet, daß die Reaktion in Gegenwart von H$_2$SO$_4$ durchgeführt wird.

6. Verfahren nach einem der Ansprüche 4 und 5, dadurch gekennzeichnet, daß die Umsetzung in einem Kristallisationsgefäß, das zur In-Gang-Setzung der hydrothermalen Reaktion dient, durchgeführt wird.

7. Verfahren nach einem der Ansprüche 1 bis 6, dadurch gekennzeichnet, daß das Kristallisationsgefäß zu 80–85% seines Volumens mit der Kristallisationslösung ausgefüllt ist.

8. Verfahren nach einem der Ansprüche 1 bis 7, dadurch gekennzeichnet, daß die Kristallisationstemperaturen 190°C bis 300°C betragen.

9. Verfahren nach Anspruch 8, dadurch gekennzeichnet, daß die Kristallisationstemperaturen 200°C bis 260°C betragen.

10. Berliniteinkristall, erhalten nach dem Verfahren gemäß einem der Ansprüche 1 bis 9.

11. Berliniteinkristall mit einem Überspannungskoeffizienten über 50 000 bei 5 MHz Grundschwingung.

FIG_1

FIG_2

FIG.3

FIG.4

EP 0 241 321 B1